(19) Europäisches Patentamt
European Patent Office
Office européen des brevets

(11) **EP 4 484 605 A1**

(12) **EUROPEAN PATENT APPLICATION**
published in accordance with Art. 153(4) EPC

(43) Date of publication:
01.01.2025 Bulletin 2025/01

(21) Application number: 22899603.9

(22) Date of filing: 19.10.2022

(51) International Patent Classification (IPC):
$C23C\ 14/34^{(2006.01)}$    $B22F\ 3/14^{(2006.01)}$
$B22F\ 9/08^{(2006.01)}$    $C22C\ 1/04^{(2023.01)}$
$C22C\ 9/01^{(2006.01)}$    $C22C\ 21/12^{(2006.01)}$

(52) Cooperative Patent Classification (CPC):
B22F 3/14; B22F 9/08; C22C 1/04; C22C 9/01;
C22C 21/12; C23C 14/34

(86) International application number:
PCT/JP2022/038962

(87) International publication number:
WO 2023/162327 (31.08.2023 Gazette 2023/35)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 25.02.2022 JP 2022028545

(71) Applicant: JX Metals Corporation
Tokyo 105-8417 (JP)

(72) Inventors:
• SATO, Yusuke
  Ibaraki (JP)
• SATO, Takanori
  Ibaraki (JP)
• KAMINAGA, Kengo
  Ibaraki (JP)

(74) Representative: Mewburn Ellis LLP
Aurora Building
Counterslip
Bristol BS1 6BX (GB)

(54) **SPUTTERING TARGET AND METHOD FOR PRODUCING SAME**

(57) There is provided a Cu-Al binary alloy sputtering target with a high Al content while suppressing occurrence of cracks on the sputtering target, and a method for manufacturing the same. A sputtering target is composed of a sintered body containing a binary alloy of Cu and Al, the rest being inevitable impurities, wherein a content (at%) of Cu and Al satisfies a relational expression of $0.48 \leq Al / (Cu + Al) \leq 0.70$, and wherein a relative density is 95% or more.

Measurement points

FIG. 1

EP 4 484 605 A1

**Description**

**FIELD OF THE INVENTION**

The present invention relates to a sputtering target (hereinafter sometimes simply referred to as "target") and a method for manufacturing the same. More particularly, the present invention relates to a sputtering target comprising a Cu-Al binary alloy and a method for manufacturing the same.

**BACKGROUND OF THE INVENTION**

Some semiconductor devices have a multilayer wiring structure, and the multilayer wiring structure includes conductor wiring, an insulating film, a diffusion barrier layer, and the like. Conventionally, pure Cu was often used for conductor wiring. However, in recent years, with the miniaturization of wiring, new problems such as electrical resistance have emerged. Along with this, search for new materials for conductor wiring is being conducted.

Patent Literature 1 discloses various intermetallic compounds as wiring materials, one of which is $CuAl_2$. Further, in order to form the intermetallic compound $CuAl_2$, Patent Literature 1 discloses vapor deposition of pure metal targets of Cu and Al by a direct current (DC) sputtering method.

Patent Literature 2 discloses that a CuAl alloy sputtering target is manufactured through processes such as forging and rolling for a wiring material application.

In Patent Literature 3, instead of a CuAl alloy sputtering target, it is proposed to use a target in which Cu and Al metals are alternately combined and which has a fan-shaped target surface shape. It is described that as a result of forming a film using this sputtering target, Cu and Al were mixed in a desired compositional concentration, and there is obtained a Cu-Al alloy film equivalent to those obtained by a sputtering target made of a Cu-Al alloy.

Further, Patent Literature 4 also discloses a method of forming a film by placing an Al chip as an additive on a Cu target and using this as a target.

**PRIOR ART**

Patent Literature

[Patent Literature 1] Japanese Patent Application Publication No. 2019-212892

[Patent Literature 2] WO 2015/151901

[Patent Literature 3] Japanese Patent Application Publication No. 2009-188281

[Patent Literature 4] Japanese Patent Application Publication No. 2004-076080

**SUMMARY OF THE INVENTION**

Since the intermetallic compound $CuAl_2$ is attracting attention as a new wiring material, a method of forming wiring by sputtering is being explored. Here, co-sputtering two types of targets, pure Cu and pure Al, as disclosed in Patent Literature 1 is complicated, and it becomes necessary to adjust various sputtering conditions in order to form the desired intermetallic compound.

Therefore, it is advantageous if the intermetallic compound $CuAl_2$ is already formed at the time of sputtering. That is, a $CuAl_2$ target material is desired.

However, as a result of examination by the present inventors, it was found that when preparing an ingot of $CuAl_2$ instead of the CuAl (Al: 0.01 wt%, 10 wt%) ingot, with the same method (processes such as rolling and forging) as disclosed in Patent Literature 2, if rolling, forging, and the like are performed on the ingot, the material cracks, and a sputtering target cannot be actually manufactured. This is presumably because $CuAl_2$ has a higher Al content than CuAl (Al: 0.01 wt%, 10 wt%) described in Patent Literature 2, resulting in lower toughness. Therefore, conventionally, it has been practically impossible to realize a Cu-Al binary alloy sputtering target with a high Al content.

In the methods of Patent Literatures 3 and 4, materials with different properties such as thermal expansion and contraction properties are close to each other, so there is a high possibility that cracks will occur when the sputtering target is heated / cooled or processed. In addition, since different materials are used, there is a high risk of impurities being mixed during sputtering. Therefore, from the viewpoint of suppressing cracking of the sputtering target and suppressing contamination of impurities during sputtering, it is preferable to use a Cu-Al binary alloy sputtering target having a more uniform composition than a sputtering target that combines different components.

The present invention has been completed in view of the above problems, and in one embodiment, one object of the present invention to provide a Cu-Al binary alloy sputtering target with a high Al content while suppressing occurrence of cracks on the sputtering target, and a method for manufacturing the same.

As a result of intensive studies, the inventors of the present invention have found that a Cu-Al binary alloy sputtering target with a high Al content can be realized by using a sintered body as the sputtering target. The present invention has been completed based on the above findings, and is exemplified as below.

[1] A sputtering target composed of a sintered body comprising a binary alloy of Cu and Al, the rest being inevitable impurities,

wherein a content (at%) of Cu and Al satisfies a relational expression of $0.48 \leq Al / (Cu + Al) \leq 0.70$, and

wherein a relative density is 95% or more.

[2] The sputtering target according to [1], wherein when the content of Al is measured by inductively coupled plasma-optical emission spectrometry for a total of 5 points of a sputtering surface of the sputtering target at a center position, an outer peripheral position, and an intermediate position therebetween, which line on two mutually orthogonal straight lines extending from a center to an outer periphery of the sputtering surface, a difference between a maximum value and a minimum value of each content is 0.2 at % or less.

[3] The sputtering target according to [1] or [2], wherein when analyzed with an X-ray diffractometer and quantitatively analyzed using an RIR (Reference Intensity Ratio) method for the results, a mass ratio of a total value of $CuAl_2$ and CuAl is 95% or more.

[4] The sputtering target according to any one of [1] to [3], wherein the binary alloy of Cu and Al comprises an intermetallic compound of $CuAl_2$ and/or CuAl.

[5] The sputtering target according to any one of [1] to [4], wherein an oxygen content is 50 to1000 mass ppm.

[6] A method for manufacturing a sputtering target composed of a sintered body comprising a binary alloy of Cu and Al, the rest being inevitable impurities,

wherein a content (at%) of Cu and Al in the sintered body satisfies a relational expression of $0.48 \leq Al / (Cu + Al) \leq 0.70$, and

wherein the method comprises:

a step of preparing atomized powder; and

a step of sintering at least one of the atomized powder and powder derived therefrom by hot pressing at a temperature of 550 °C or higher.

[7] The method according to [6], further comprising a step of preparing an ingot in which the content (at%) of Cu and Al satisfies the relational expression of $0.48 \leq Al / (Cu + Al) \leq 0.70$ before preparing the atomized powder, and wherein the atomized powder is prepared from the ingot.

[8] The method according to [6] or [7], further comprising a step of further pulverizing the atomized powder prior to the sintering.

[9] The method according to any one of [6] to [8], wherein the binary alloy of Cu and Al comprises an intermetallic compound of $CuAl_2$ and/or CuAl.

According to the present invention, it is possible to provide a Cu-Al binary alloy sputtering target with a high Al content while suppressing occurrence of cracks on the sputtering target, and a method for manufacturing the same.

**BRIEF DESCRIPTION OF THE DRAWINGS**

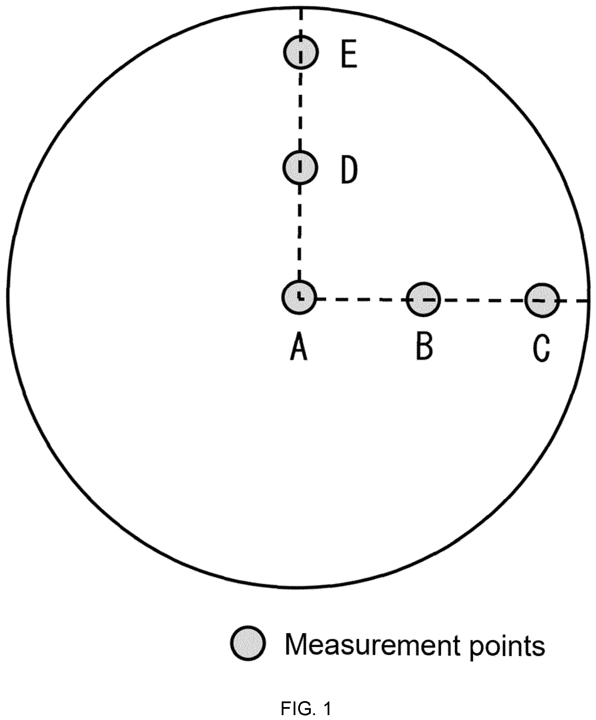

FIG. 1 is a diagram showing measurement points of a sputtering target for evaluating composition uniformity.

**DETAILED DESCRIPTION OF THE INVENTION**

Hereinafter, embodiments of the present invention will now be described in detail. It should be understood that the present invention is not intended to be limited to the following embodiments, and any change, improvement or the like of the design may be appropriately added based on ordinary knowledge of those skilled in the art without departing from the spirit of the present invention.

(1. Composition)

In one embodiment, the present invention is a sputtering target composed of a sintered body comprising a binary alloy of Cu and Al, with the rest being inevitable impurities. The sputtering target may be provided with a backing plate and, in addition, may include a bonding layer.

The shape of the sputtering target is also not particularly limited, but typically it can be a plate shape (for example, circular, rectangular, and the like).

In the sputtering target, the content (at%) of Cu and Al satisfies the relational expression of $0.48 \leq Al / (Cu + Al) \leq 0.70$.

By setting the content of Al to 48 at % or more and 70 at % or less with respect to the total content of Cu and Al, a conductor made of the intermetallic compound of Cu and Al can be satisfactorily formed. This conductor can be expected to have properties such as excellent conductivity and adhesion between a conductor and an insulator. From this point of view, the content of Al relative to the total content of Cu and Al is preferably 50 at% or more, more preferably 55 at% or more, even more preferably 62 at% or more, and even more preferably 66 at% or more.

In addition, from the same point of view, the content of Al is preferably 69 at % or less, and more preferably 68 at % or less, relative to the total content of Cu and Al.

Preferably, the sputtering target comprises an intermetallic compound of $CuAl_2$ and/or CuAl, and more preferably, the sputtering target is an intermetallic compound of $CuAl_2$ and/or CuAl. That is, the content of Cu and Al even more preferably satisfy $Al / (Cu + Al) = 0.67 \pm 0.02$, or $Al / (Cu + Al) = 0.50 \pm 0.02$, even more preferably satisfy $Al / (Cu + Al) = 0.67 \pm 0.01$, or $Al / (Cu + Al) = 0.50 \pm 0.01$, and even more preferably, the content of Cu and Al satisfy $Al / (Cu + Al) = 0.67$, or $Al / (Cu + Al) = 0.50$.

If a $CuAl_2$ or CuAl intermetallic compound target material can be prepared, there is no need to separately prepare pure metal targets of Cu and Al for forming a $CuAl_2$ wiring material or a CuAl wiring material, and furthermore, there is lower risk of contamination by impurities during sputtering. Therefore, the purity of the sputtering target of the present embodiment is preferably 4N (99.99% by mass) or higher, more preferably 4N5 (99.995% by mass) or higher, and even more preferably 5N (99.999% by mass) or higher.

Here, when the purity of the sputtering target is 4N (99.99% by mass) or more, it means when the composition is analyzed by glow discharge mass spectrometry (GDMS), the total amount of Na, P, S, K, Ca, Cr, Fe, Ni, As, Ag, Sb, Bi, Th, U contained in the sputtering target is less than 0.01 % by mass (100 mass ppm).

In addition, for the content of Cu and Al, when manufacturing a sputtering target from an ingot made of an intermetallic compound of Cu and Al as described later, it can be the content of Cu and Al in the ingot, and when measured from a product sputtering target, the composition of the sputtering target can be determined by inductively coupled plasma-optical emission spectroscopy (ICP-OES).

Although the oxygen content of the sputtering target is not particularly limited, it is inevitably 50 mass ppm or more due to the manufacturing method, and is preferably 1500 mass ppm or less. Typically, the lower limit of the oxygen content may be 200 ppm by mass or more, or 500 ppm by mass or more, and the upper limit of the oxygen content may be 1000 ppm by mass or less. The oxygen content of the sputtering target is measured by an inert gas fusion-infrared absorption method (for example, TCH600 manufactured by LECO).

(2. Relative density)

In one embodiment of the present invention, the sputtering target has a relative density of 95% or more. By increasing the relative density of the target, it is possible to suppress the occurrence of cracks during sputtering target processing and sputtering. In addition, a higher relative density of the target is preferable for stable sputtering with less arcing. The relative density is preferably 97% or higher, more preferably 98% or higher, even more preferably 99% or higher. Although there is no particular upper limit for the relative density, for example, it may be 100% or less, or may be 99.9% or less, or may be 99.5% or less, or may be 99.0% or less.

The relative density is calculated from the formula: relative density = measured density / theoretical density $\times$ 100(%). Here, the measured density is a value obtained by dividing the weight by the volume, and the volume is measured by the Archimedes method. Assuming that the entire sputtering target is $CuAl_2$ ($\theta$ phase) and CuAl ($\eta$ phase), the theoretical density of $CuAl_2$ ($\theta$ phase) is 4.35 g/cm$^3$, and the theoretical density of CuAl ($\eta$ phase) is 5.36 g/cm$^3$, and the relative density is calculated by their weighted average. The ratio of $CuAl_2$ ($\theta$ phase) and CuAl ($\eta$ phase) is calculated from the composition of the sputtering target. The relative density calculated using this theoretical density may exceed 100%.

From the viewpoint of suppressing the occurrence of cracks during sputtering target processing and sputtering, a higher relative density is desirable. However, by simply melting Cu and Al or a Cu-Al alloy and casting an ingot, even if the relative density can be increased, it is likely to crack during cutting or fixing, and it is difficult to obtain a sputtering target as a product. In the present invention, as described later, by preparing atomized powder and further sintering this atomized powder and the like under predetermined conditions, a Cu-Al binary alloy sputtering target with a high relative density and a resistance to cracking can be realized for the first time.

(3. Uniformity of composition)

In one embodiment of the invention, it is preferable that, when the content of Al is measured by ICP-OES for a total of 5 points of the sputtering surface of the flat plate-shaped sputtering target at the center position, the outer peripheral position, and the intermediate position therebetween, which line on two mutually orthogonal straight lines extending from the center to the outer periphery of the sputtering surface, a difference between a maximum value and a minimum value of each content is 0.2 at % or less. In addition, the outer peripheral position is a position of 1/8 of the length between the center to the outermost periphery of the sputtering target in the direction from the outermost periphery toward the center. The intermediate position between the center position and the outer peripheral position is a position at the center point of a straight line connecting the central position and the outer peripheral position. In this manner, the difference in Al content at these measurement points is small and the composition uniformity is high, so that the composition of the sputtering target is uniform at each point, which helps to form a uniform conductive layer.

From this point of view, it is more preferable that the difference between the maximum value and the minimum value of the Al content measured based on the above method is 0.1 at % or less. This compositional uniformity cannot be achieved with, for example, a sputtering target in which Cu single metal and Al single metal are alternately arranged or mixed. However, by preparing atomized powder as described later, it is possible to achieve a high level of uniformity.

Here, referring to FIG. 1, when the sputtering surface of the sputtering target is circular, the center A is the center of the circle, and the five points of the center position A, outer peripheral positions E and C, and intermediate positions B and D between them are arranged in an L shape. The outer peripheral positions E and C are positions at 1/8 of the length between the center A to the outermost periphery in the direction from the outermost periphery to the center A of the sputtering target. If the sputter surface of the sputtering target is rectangular, its center is the intersection of the diagonals.

(4 Crystal structure)

The crystal structure of the sputtering target can be identified by analyzing the sputtering surface with XRD (X-ray diffractometer). The mass ratio of each crystal phase can be obtained by quantitatively analyzing the results of XRD analysis using the RIR (Reference Intensity Ratio) method. Here, the RIR method is a method of determining the mass ratio of the crystal phase from the ratio of the RIR value and the value of the strongest peak intensity of each crystal phase obtained from the result of XRD. When the sputtering target contains crystal phases A, B, C, ... , the mass ratio $X_A$ of crystal phase A is calculated by the following formula.

$$X_A = I_A k_A / (I_A k_A + I_B k_B + I_C k_C + \cdots)$$

In which, I is the intensity of the strongest X-ray peak of each crystal phase, and k is the RIR value of each crystal phase. As the RIR value, the value described in the Powder Diffraction File (PDF) database of the International Center for Diffraction Data can be used.

By quantitative analysis using the RIR method, it is possible to obtain quantitative values for each phase of Cu, Al, $CuAl_2$, and CuAl, and thus to obtain the mass ratio of the total value of $CuAl_2$ + CuAl.

The mass ratio of the total value of $CuAl_2$ + CuAl is preferably 95% or more, more preferably 98% or more. Thereby, a conductor composed of an intermetallic compound of Cu and Al can be formed satisfactorily. In addition, when $CuAl_2$ is the main phase, the mass ratio of $CuAl_2$ is preferably 70% or more, more preferably 90% or more, and even more preferably 95% or more. Here, the main phase means the most abundant crystal phase among all the crystal phases contained in the sputtering target. When CuAl is the main phase, the mass ratio of CuAl is preferably 70% or more, more preferably 90% or more, and even more preferably 95% or more. Thereby, a conductor composed of an intermetallic compound of Cu and Al can be formed satisfactorily. Furthermore, in a preferred embodiment of the present invention, the mass ratio of the sum of $CuAl_2$ + CuAl is 100%, that is, no Cu single phase or Al single phase is included.

(5. Manufacturing method)

Although a specific manufacturing method is not limited as long as the sputtering target of the present invention is composed of a sintered body, the manufacturing method in one embodiment includes at least the following steps:

·a step of preparing atomized powder; and

·a step of sintering at least one of the atomized powder and powder derived therefrom by hot pressing at a temperature of 550 °C or higher.

More preferably, an ingot is prepared so that the content (at%) of Cu and Al satisfies the relational expression of $0.48 \le Al / (Cu + Al) \le 0.70$, and atomized powder is prepared from this ingot.
Moreover, the atomized powder may be further pulverized, and after the pulverization, it may be sintered by a hot press.
Below, each process is explained in full detail.

5-1. Process of preparing ingot

As will be described later, it is not always necessary to prepare an ingot if the atomized powder which is the raw material for the Cu-Al binary alloy can be prepared. However, in some embodiments of the present invention, it is preferable that, desired Cu and Al are dissolved, or desired Cu-Al alloy is dissolved, thereby preparing an ingot so that the content (at %) of Cu and Al satisfies the relational expression of $0.48 \le Al / (Cu + Al) \le 0.70$. In that case, the subject for dissolution can be selected according to the components of the final target as described above. For example, when the component of the target is $CuAl_2$, a $CuAl_2$ alloy may be melted, or Cu and Al may be set to an atomic ratio of 1:2 and melted. By performing melting to prepare an ingot, the raw material can be once stirred to promote homogenization.
Although the melting temperature is not particularly limited, it is preferably 800 to 1000 °C, more preferably 850 to 950 °C.
A desired ingot can be prepared by pouring the molten metal into a mold.

5-2. Process of preparing atomized powder from ingot

Atomized powder can be obtained by subjecting the obtained ingot to atomization treatment. It should be note that although it is preferable to use the above-mentioned ingot as a raw material, there is no particular limitation as long as atomized powder having a desired atomic ratio of Cu and Al can be prepared. For example, when the component of the target is $CuAl_2$, then Cu and Al may be put into an atomizer and melted so that the atomic ratio is 1:2 to prepare the atomized powder. By pulverizing with atomizing treatment, it can be subjected to hot pressing in the post-process, and it becomes possible to manufacture a target. In addition, uniformity of the material can be promoted by preparing atomized powder.
Atomization treatment includes disk atomization, water atomization, gas atomization, and the like, and gas atomization is preferred. The gas atomization conditions are not particularly limited, but the temperature of the atomization treatment is preferably 700 to 900 °C, more preferably 750 to 850 °C. The gas pressure is also not particularly limited, but is preferably 1 to 10 MPa, more preferably 3 to 7 MPa.

5-3. Process of pulverizing atomized powder

The atomized powder may then be hot-pressed to form a sintered body, but in another embodiment, the atomized powder may be further pulverized before being hot-pressed. Thereby, the relative density of the target can be improved. Furthermore, the relative density is improved, so that the sputtering characteristics can be improved.
The means for pulverizing is not particularly limited, but a known mechanical pulverizer can be used (for example, a tabletop impact pulverizer (for example, SP Mill manufactured by nylabo)).
The particle size (particle size D50 at the volume-based 50% cumulative frequency in particle size distribution measured by a laser diffraction method) of the atomized powder or the powder obtained by pulverizing the atomized powder is preferably about 35 µm to 45 µm. In addition, when the step of pulverizing the atomized powder is not performed, the particle size of the atomized powder may be larger than the above range, for example, 45 µm to 100 µm.

5-4. Hot pressing process

A sintered body can be obtained by putting the atomized powder or powder obtained by pulverizing the atomized powder into a hot press container and performing hot pressing. Hot pressing is performed under a condition of at least 550 °C or higher. By carrying out at 550 °C or higher, workability is improved (for example, the possibility of cracking during manufacturing can be reduced). Moreover, the relative density is also improved by carrying out at 550 °C or higher. Although the upper limit of the temperature is not particularly limited, it is 700 °C or lower, typically 600 °C or lower. More preferably, it is 560 to 580 °C.

The pressure is not particularly limited, but is preferably 200 to 450 kgf/cm$^2$, more preferably 250 to 350 kgf/cm$^2$. In addition, the holding time is also not particularly limited, but preferably 3 to 8 hours, more preferably 5 to 6 hours.

5-5. Other processes

After the sintered body is obtained by hot pressing, other processing may be performed as appropriate. For example, hot isostatic pressure treatment may be performed to further improve the relative density. Moreover, in order to finish the sintered body into the shape of a product for shipment, machining such as grinding and/or cutting may be performed as appropriate. Furthermore, the sintered body may then be bonded to a backing plate to form a final product. Conditions for these other processes are not particularly limited, and conditions known in the art may be appropriately adopted.

In addition, as described above, since the powder is sintered in the manufacturing method, a rolling process or a forging process may not be included.

The sputtering target according to one embodiment of the present invention has excellent workability and is less likely to crack during processing (for example, grinding, cutting, and the like) in manufacture. Also, since the relative density is relatively high, it is possible to avoid wetting with grinding oil or the like. Moreover, since it is manufactured as a sintered body, it is not necessary to carry out a rolling process and a forging process, and the possibility of cracks caused by these rolling process and forging process can be eliminated.

Furthermore, the sputtering target according to one embodiment of the present invention has excellent material uniformity, and for example, has less unevenness in appearance (such as unevenness in color). For example, when the structure is observed by means such as SEM, there is little difference in gradation depending on the observation location.

**EXAMPLES**

The present invention will now be described in greater detail by way of examples, but the descriptions here are for illustrative purposes only and are not intended to be limiting.

(Examples 1 to 3, Comparative Examples 1 and 2)

An ingot was prepared by melting (at 900 °C) a CuAl$_2$ intermetallic compound having a composition of 66.7 at% $\pm$ 0.5 at% Al, the rest being Cu and unavoidable impurities. Next, the ingots of Examples 1 to 3 and Comparative Example 2 were subjected to atomization (gas atomization). The temperature of the atomizing treatment was 780 °C, and the gas pressure was 5 MPa. In some examples (Example 1), the resulting atomized powder was further ground by an SP mill. The D50 of the particles before pulverization was 75 $\mu$m, and the D50 of the particles after pulverization was 40 $\mu$m. Note that in Comparative Example 1, after the ingot was prepared, the production of the sputtering target was attempted by rolling and forging without performing the atomizing treatment or the like.

(Example 4)

An ingot was prepared by melting (at 900 °C) an intermetallic compound of Cu and Al having a composition of 62.7 at% $\pm$ 0.5 at% Al, the rest being Cu and unavoidable impurities. Next, the ingot was subjected to atomization (gas atomization). The temperature of the atomizing treatment was 780° C, and the gas pressure was 5 MPa.

(Example 5)

An ingot was prepared by melting (at 900 °C) an intermetallic compound of CuAl having a composition of 50 at% $\pm$ 0.5 at% Al, the rest being Cu and unavoidable impurities. Next, the ingot was subjected to atomization (gas atomization). The temperature of the atomizing treatment was 780° C, and the gas pressure was 5 MPa.

For the obtained powder, it was subjected to hot pressing under the conditions of temperature 570 °C (in some Examples, 550 °C, 555 °C, and in some Comparative Examples, 525 °C); 250 to 350 kgf/cm$^2$; and holding time of 5 to 6 hours. There by obtaining a circular sintered body having a thickness of 16 to 17 mm and a diameter of 460 mm. Finally, processing such as cutting and grinding was performed on each sintered body. The presence or absence of cracks at that time was confirmed.

Relative densities of the obtained sintered bodies were measured as described above. As the theoretical density, except for Examples 4 and 5, a weighted average value (4.38 g/cm$^3$) was used with the proportions of CuAl$_2$ ($\theta$ phase) and CuAl ($\eta$ phase) set to 97.5 vol % and 2.5 vol %, respectively. In Example 4, a theoretical density of 4.39 g/cm$^3$ was used, and in Example 5, a theoretical density of 5.36 g/cm$^3$ of CuAl ($\eta$ phase) was used, and the relative density was measured in the same manner.

Also, the purity and oxygen content of the sintered body were measured as described above. In Comparative Examples 1 and 2, the workability was poor and they could not be used as sputtering targets, so the purity and oxygen content were not measured.

Also, in the sintered bodies of Examples 2 and 5, about 10 g of samples were cut out from each of the five points A to E shown in FIG. 1 as described above. Then, the Al content of each sample was measured by ICP-OES (Agilent 5110 ICP-OES manufactured by Agilent Technologies, Inc.). Specifically, point A was the central position, points B and D were the intermediate positions, and points C and E were the outer peripheral positions. When cutting out the samples, care was taken to only cut out samples within 5 mm of these points. When the difference between the maximum and minimum values of each content was calculated, it was 0.1 at% in Examples 2 and 5.

In addition, the sputtered surfaces of the sintered bodies of Examples 2, 4 and 5 were analyzed by an X-ray diffractometer (model MiniFlex 600 manufactured by Rigaku Corporation), and the RIR (Reference Intensity Ratio) method was applied to quantitively determine CuAl$_2$ ($\theta$ phase) and CuAl ($\eta$ phase). As the calculation method, the integrated intensity of the strongest peak of each phase in the diffraction pattern obtained by the X-ray diffractometer is multiplied by the RIR value, and the obtained value was divided by the sum of the values obtained by multiplying the integrated intensity of the strongest peak of each phase by the RIR value. As the RIR value, the values described in the Powder Diffraction File (PDF) database of the International Diffraction Data Center (ICSD Nos. 01-071-5027 and 03-065-1228) were used. Specifically, 2.74 (No.01-071-5027) was used as the RIR value of CuAl$_2$ ($\theta$ phase), and 2.06 (No.03-065-1228) was used as the RIR value of CuAl ($\eta$ phase). The analysis conditions were set as follows.

·X-ray source: CuK $\alpha$-ray

·Measuring range: $2\theta$ = 10° to 90°

·Step: 0.01°

·Scan speed: 20.0 °/min

·Detector: High-speed one-dimensional detector D/teX Ultra

·Tube voltage: 40 kV

·Tube current: 30mA

Tables 1 to 3 show the production conditions and evaluation details for each Example and Comparative Example.

Table 1

| | Manufacturing method | | | | Target characteristics | | | |
|---|---|---|---|---|---|---|---|---|
| | Melting temperature | Atomizing temperature | Pulverization | Hot press temperature | Relative density | Oxygen content | Purity | Workability |
| Example 1 | 900 °C | 780 °C | ○ | 570 °C | 100% | 950ppm | 4N | ○ |
| Example 2 | 900 °C | 780 °C | - | 570 °C | 97% | 730ppm | 5N | ○ |
| Example 3 | 900 °C | 780 °C | - | 550 °C | 95% | 730ppm | 5N | ○ |
| Example 4 | 900 °C | 780 °C | - | 570 °C | 100% | 780ppm | 4N | ○ |
| Example 5 | 900 °C | 780 °C | - | 555 °C | 98% | 300ppm | 4N | ○ |
| Comparative Example 1 | 900 °C | - | - | - | 99% | - | - | X (crack) |

(continued)

| | Manufacturing method | | | | Target characteristics | | | |
|---|---|---|---|---|---|---|---|---|
| | Melting temperature | Atomizing temperature | Pulverization | Hot press temperature | Relative density | Oxygen content | Purity | Workability |
| Comparative Example 2 | 900 °C | 780 °C | - | 525 °C | 93% | - | - | X (crack and wet) |

Table 2

| Measurement points | Example 2 | Example 5 |
|---|---|---|
| | Al [at%] | Al [at%] |
| A | 65.9 | 49.6 |
| B | 65.9 | 49.6 |
| C | 65.9 | 49.7 |
| D | 65.9 | 49.7 |
| E | 65.8 | 49.7 |

Table 3

| | Mass ratio[%] | |
|---|---|---|
| | $CuAl_2$ ($\theta$ phase) | CuAl ($\eta$ phase) |
| Example 2 | 96.1 | 3.9 |
| Example 4 | 75.3 | 24.7 |
| Example 5 | 4.9 | 95.1 |

In Examples 1 to 5, the target was able to manufacture as a product without cracking. Moreover, the relative density was 95% or more. Furthermore, the sputtering target of the present invention was resistant to repeated heating and cooling, and was less likely to crack during sputtering. Further, from the analysis of the composition for Examples 2 and 5, it was found that the Al content was almost the same at each measurement point, and although not shown in Table 2, the rest at each measurement point was Cu. That is, it was found that the sputtering target of the present invention has good uniformity of the composition of Cu and Al. In addition, as shown in Table 2, the elemental composition ratio of the finally manufactured sputtering target may be slightly different from the composition ratio of the raw materials.

Comparative Example 1 is an example in which an attempt was made to manufacture an ingot by melting and then rolling and forging. Cracks occurred during cutting and fixing of the ingot before it was possible to perform rolling and forging.

In Comparative Example 2, after melting to produce an ingot, atomized powder was prepared under the same conditions as in Examples 2 and 3. However, the temperature of the hot press was too low, and cracks and wetting with grinding oil occurred during processing (cutting, grinding) to finish the final product.

In Example 1, the relative density of the final product was improved compared to Example 2 because the atomized powder was further pulverized after being prepared.

Furthermore, as can be seen from Table 3, an intermetallic compound of Cu and Al can be generated without any problem in the present invention. In addition, in Examples 2 and 4, since a large amount of $CuAl_2$ ($\theta$ phase) was formed, it is considered to be advantageous in forming a sputtered film having a relatively uniform $CuAl_2$ composition. In Example 5, since a large amount of CuAl ($\eta$ phase) was formed, it is considered advantageous for forming a sputtered film having a relatively uniform CuAl composition. As shown in Table 3, in these examples, the mass ratio of the total value of $CuAl_2$ + CuAl was 100%, that is, there was no Cu single phase or Al single phase.

Specific embodiments of the present invention have been described above. The above embodiments are merely specific examples of the present invention, and the present invention is not limited to these embodiments. For example, technical features disclosed in one of the embodiments described above may be applied to other embodiments.

**Claims**

1. A sputtering target composed of a sintered body comprising a binary alloy of Cu and Al, the rest being inevitable impurities,

    wherein a content (at%) of Cu and Al satisfies a relational expression of $0.48 \leq Al / (Cu + Al) \leq 0.70$, and
    wherein a relative density is 95% or more.

2. The sputtering target according to claim 1, wherein when the content of Al is measured by inductively coupled plasma-optical emission spectrometry for a total of 5 points of a sputtering surface of the sputtering target at a center position, an outer peripheral position, and an intermediate position therebetween, which line on two mutually orthogonal straight lines extending from a center to an outer periphery of the sputtering surface, a difference between a maximum value and a minimum value of each content is 0.2 at % or less.

3. The sputtering target according to claim 1 or 2, wherein when analyzed with an X-ray diffractometer and quantitatively analyzed using an RIR (Reference Intensity Ratio) method for the results, a mass ratio of a total value of $CuAl_2$ and CuAl is 95% or more.

4. The sputtering target according to any one of claim 1 to 3, wherein the binary alloy of Cu and Al comprises an intermetallic compound of $CuAl_2$ and/or CuAl.

5. The sputtering target according to any one of claim 1 to 4, wherein an oxygen content is 50 to1000 mass ppm.

6. A method for manufacturing a sputtering target composed of a sintered body comprising a binary alloy of Cu and Al, the rest being inevitable impurities,

    wherein a content (at%) of Cu and Al in the sintered body satisfies a relational expression of $0.48 \leq Al / (Cu + Al) \leq 0.70$, and
    wherein the method comprises:

        a step of preparing atomized powder; and
        a step of sintering at least one of the atomized powder and powder derived therefrom by hot pressing at a temperature of 550 °C or higher.

7. The method according to claim 6, further comprising a step of preparing an ingot in which the content (at%) of Cu and Al satisfies the relational expression of $0.48 \leq Al / (Cu + Al) \leq 0.70$ before preparing the atomized powder, and wherein the atomized powder is prepared from the ingot.

8. The method according to claim 6 or 7, further comprising a step of further pulverizing the atomized powder prior to the sintering.

9. The method according to any one of claims 6 to 8, wherein the binary alloy of Cu and Al comprises an intermetallic compound of $CuAl_2$ and/or CuAl.

Measurement points

FIG. 1

**INTERNATIONAL SEARCH REPORT**

| International application No. |
| --- |
| **PCT/JP2022/038962** |

### A. CLASSIFICATION OF SUBJECT MATTER

*C23C 14/34*(2006.01)i; *B22F 3/14*(2006.01)i; *B22F 9/08*(2006.01)i; *C22C 1/04*(2023.01)i; *C22C 9/01*(2006.01)i;
*C22C 21/12*(2006.01)i
FI: C23C14/34 A; B22F9/08 A; C22C9/01; C22C21/12; B22F3/14 D; C22C1/04 A; C22C1/04 C

According to International Patent Classification (IPC) or to both national classification and IPC

### B. FIELDS SEARCHED

Minimum documentation searched (classification system followed by classification symbols)

C23C14/34; B22F3/14; B22F9/08; C22C1/04; C22C9/01; C22C21/12

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII)

### C. DOCUMENTS CONSIDERED TO BE RELEVANT

| Category* | Citation of document, with indication, where appropriate, of the relevant passages | Relevant to claim No. |
| --- | --- | --- |
| Y | JP 2022-6690 A (ULVAC JAPAN, LTD.) 13 January 2022 (2022-01-13) paragraphs [0011]-[0125] | 1, 4-6, 9 |
| A | | 2, 3, 7, 8 |
| Y | 中村保 他, DCパルス通電加熱焼結法による異種金属素粉末の加圧反応焼結特性, 日本機械学会論文集, 25 February 2001, vol. 67, no. 660, pages 2692-2699, (NAKAMURA, Tamotsu et al. Pressure Sintering Characteristics with Chemical Reaction between Dissimilar Metal Powders by DC Pulse Resistance-Sintering Process. Transactions of the JSME.) page 2, left column, line 20 to page 8, right column, line 20 | 1, 4-6, 9 |

☐ Further documents are listed in the continuation of Box C.     ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **05 December 2022** | **20 December 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/038962**

| Patent document cited in search report | Publication date (day/month/year) | Patent family member(s) | Publication date (day/month/year) |
|---|---|---|---|
| JP 2022-6690 A | 13 January 2022 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019212892 A
- WO 2015151901 A
- JP 2009188281 A
- JP 2004076080 A